# FASCICULE DE BREVET EUROPEEN

(11) **EP 1 234 339 B1**
(45) Date de publication et mention de la délivrance du brevet: **01.02.2012**
(21) Numéro de dépôt: 00974602.5
(22) Date de dépôt: 30.10.2000
(51) Int. Cl.: H01L 27/146

(54) **BOÎTIER SEMI-CONDUCTEUR OPTIQUE ET PROCEDE DE FABRICATION D'UN TEL BOÎTIER**
GEHÄUSE FÜR OPTISCHE HALBLEITERELEMENTE UND HERSTELLUNGSVERFAHREN SOLCHER GEHÄUSE
OPTICAL SEMICONDUCTOR HOUSING AND METHOD FOR MAKING SAME

(30) Priorité: 04.11.1999 FR 9913777
(43) Date de publication de la demande: 28.08.2002
(73) Titulaire: STMicroelectronics S.A., 92120 Montrouge (FR)
(72) Inventeur: EXPOSITO, Juan, F-38330 St. Nazaire les Eymes (FR); BRECHIGNAC, Rémi, F-38000 Grenoble (FR)
(74) Mandataire: Casalonga, Axel
(86) Numéro de dépôt international: PCT/FR2000/003021
(87) Numéro de publication internationale: WO 2001/033636

(56) Documents cités:
- JP-A- 04 152 772
- JP-A- 06 132 423
- JP-A- 08 172 177
- US-A- 5 763 943
- PATENT ABSTRACTS OF JAPAN vol. 1999, no. 14, 22 décembre 1999 (1999-12-22) -& JP 11 261044 A (MATSUSHITA ELECTRIC IND CO LTD), 24 septembre 1999 (1999-09-24)
- PATENT ABSTRACTS OF JAPAN vol. 013, no. 551 (E-857), 8 décembre 1989 (1989-12-08) -& JP 01 228178 A (HITACHI LTD), 12 septembre 1989 (1989-09-12)

## Description

La présente invention concerne un boîtier semi-conducteur optique et un procédé de fabrication d'un tel boîtier.

Le document JP-A-11 261044 décrit un boîtier semi-conducteur optique comprenant deux composants semi-conducteurs empilés sur une plaque support, dont un premier composant fixé sur la plaque support par des billes de connexion électrique et un second composant optique relié à la plaque support par des fils de connexion électrique. Un couvercle en forme de cuvette enveloppe à distance les composants et les fils de connexion électrique et est fixé sur la plaque support, ce couvercle présentant une plaque transparente en face du capteur du second composant.

Le document US-A-5 763 943 décrit également un boîtier semi-conducteur optique à composants semi-conducteurs empilés sur une plaque support, dans lequel le composant semi-conducteur optique est relié à la plaque support par un substrat intermédiaire auquel ce composant optique est relié par des fils de connexion électrique.

Le document JP-A-04 152772 décrit un boîtier semi-conducteur optique comprenant deux composants semi-conducteurs empilés sur le fond d'un support en forme de cuvette, dans lequel des fils de connexion électrique relient le second composant à la face frontale de l'enveloppe de cette cuvette, ces fils étant noyés dans un anneau d'encapsulation entourant à distance le capteur optique frontal de ce second composant, et dans lequel une pastille complémentaire constituant un filtre est fixée sur le second composant à l'intérieur dudit anneau.

Le but de la présente invention est de proposer une structure simplifiée d'un boîtier semi-conducteur optique comprenant des composants semi-conducteurs empilés et un procédé simplifié de fabrication d'un tel boîtier de telle sorte que ce boîtier soit susceptible d'être utilisé immédiatement pour de préférence délivrer des données d'images à partir des données d'un composant semi-conducteur à capteur optique et de telle sorte qu'il présente un encombrement réduit et des qualités d'étanchéité et de tenue aux chocs non encore atteintes pour un tel Boîtier

La présente invention a tout d'abord pour objet un boîtier semi-conducteur optique qui comprend une plaque support comprenant un réseau de connexion électrique ; un premier composant semi-conducteur tel qu'un microprocesseur dont une face est portée par une face avant de ladite plaque support ; un second composant semi-conducteur dont une face avant comprend un capteur optique et dont une face arrière est fixée sur une face avant dudit premier composant ; des premiers moyens de connexion électrique dudit premier composant à la face avant de ladite plaque support ; des seconds moyens de connexion électrique dudit second composant à la face avant de ladite plaque support comprenant des fils de connexion électrique dont les extrémités sont respectivement connectées d'une part à la face avant dudit second composant et d'autre part à la face avant de ladite plaque support ; et des moyens de connexion électrique extérieure disposés sur une partie découverte de ladite plaque support.

Selon l'invention, le boîtier semi-conducteur optique comprend un bloc d'enrobage en un matériau transparent formé sur la face avant de ladite plaque support, encapsulant lesdits composants et lesdits moyens de connexion électrique et dont la face avant s'étend parallèlement et en avant du capteur optique ; ladite plaque support portant, sur une partie découverte de sa face avant, des composants électroniques passifs disposés à l'extérieur dudit bloc d'enrobage et connectés électriquement audit réseau.

Selon l'invention, lesdits premiers moyens de connexion électrique peuvent comprendre des billes de connexion électrique et de fixation interposées entre la face arrière dudit premier composant et la face avant de ladite plaque support.

Selon l'invention, lesdits moyens de connexion électrique extérieure peuvent comprendre des billes de connexion électrique disposées sur la face arrière de ladite plaque support opposée auxdits composants.

Selon l'invention, lesdits moyens de connexion électrique extérieure peuvent comprendre un organe de branchement électrique fixé sur ladite plaque support.

Selon l'invention, ledit organe de branchement électrique peut être fixé sur la face avant de ladite plaque support.

La présente invention a également pour objet un procédé de fabrication d'un boîtier semi-conducteur optique, qui comprenant, la fixation et la connexion électrique d'une face arrière d'un premier composant semi-conducteur tel qu'un microprocesseur sur une face avant d'une plaque support de connexion électrique qui comprend des lignes internes et/ou externes constituant un réseau de connexions électriques présentant des zones et/ou plots de connexions électriques, par l'intermédiaire de billes de connexion électrique disposées entre des zones de connexion électrique desdites faces ; la fixation de la face arrière d'un second composant semi-conducteur dont une face avant comprend un capteur optique, sur une face avant dudit premier composant ; la fixation des extrémités de fils de connexion électrique pour relier des zones de connexion électrique de la face avant dudit second composant et de la face avant de ladite plaque support.

A la suite, le procédé comprend l'encapsulation desdits composants empilés sur ladite plaque support et desdits moyens de connexion électrique dans un bloc en un matériau d'enrobage transparent formé sur la face avant de ladite plaque support, encapsulant lesdits composants empilés sur cette plaque support et lesdits moyens de connexion électrique et dont la face avant s'étend parallèlement et en avant du capteur optique, puis la fixation de moyens de connexion électrique extérieure sur une partie découverte de ladite plaque support et la fixation de composants électroniques passifs sur une partie découverte de la face avant de ladite plaque support et la connexion électrique de ces composants électroniques passifs audit réseau.

Selon l'invention, la fixation de moyens de connexion électrique extérieure peut comprendre la dépose des billes de connexion électrique sur des zones de connexion électrique prévues sur la face arrière de ladite plaque support.

Selon l'invention, la fixation de moyens de connexion électrique extérieure peut comprendre la fixation d'au moins un organe de connexion électrique sur des zones de connexion électrique prévues sur la face avant de ladite plaque support.

La présente invention sera mieux comprise à l'étude d'un boîtier semi-conducteur optique et de son procédé de fabrication, décrits à titre d'exemples non limitatifs et illustrés par le dessin sur lequel :
- la figure 1 représente une première étape de fabrication d'un boîtier selon la présente invention ;
- la figure 2 représente une seconde étape de fabrication dudit boîtier ;
- la figure 3A représente une troisième étape de fabrication dudit boîtier selon une première variante d'exécution de ce dernier ;
- la figure 3B représente une troisième étape de fabrication dudit boîtier, selon une seconde variante d'exécution de ce dernier ;
- la figure 4A représente une quatrième étape de fabrication dudit boîtier selon une première variante d'exécution de ce dernier ;
- la figure 4B représente une quatrième étape de fabrication dudit boîtier selon une seconde variante d'exécution de ce dernier ;
- et la figure 5 représente une vue de dessus du boîtier selon la figure 4A.

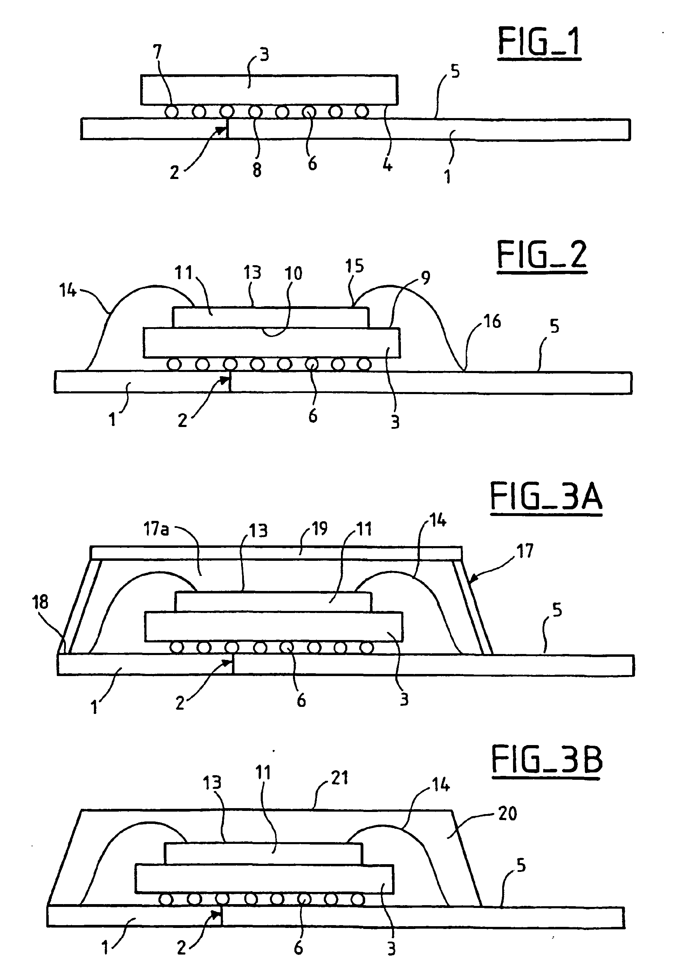

En se reportant à la figure 1, on voit qu'on dispose, de façon préfabriquée, d'un substrat 1 constitué par une plaque support qui présente des lignes internes et/ou externes constituant un réseau 2 de connexions électriques et d'un premier composant semi-conducteur 3 tel qu'un microprocesseur ou coprocesseur.

Dans une première étape de fabrication, on fixe une face arrière 4 du premier composant 3 sur une face avant 5 de la plaque support 1 par l'intermédiaire d'une multiplicité de billes métalliques 6 réparties sous la forme d'une matrice. Ces billes 6 constituent des connexions électriques entre respectivement des plots métalliques 7 et des plots métalliques 8 réalisés en surface sur la face arrière 4 du premier composant 3 et la face avant 5 de la plaque support 1.

En se reportant à la figure 2, on voit que, dans une seconde étape de fabrication, on fixe par l'intermédiaire d'une couche de colle, ou autre moyen de fixation, la face arrière 10 d'un second composant semi-conducteur optique 11 sur la face avant 9 du premier composant 3, la face avant 12 du composant optique 11 présentant dans sa partie centrale un capteur optique 13.

Ensuite, on fixe l'une des extrémités de fils de connexion électrique 14 à des plots métalliques 15 formés en surface sur la face avant 13 du second composant 11 autour du capteur optique 13 et on fixe l'autre extrémité des fils de connexion électrique 14 à des plots métalliques 16 du réseau 2, formés en surface sur la face avant 5 de la plaque support 1 et à distance de la périphérie du premier composant 3.

Dans une troisième étape de fabrication représenté sur la figure 3A, selon une première variante d'exécution, on réalise une encapsulation en disposant, au-dessus et à distance des composants 3 et 11 et des fils de connexion électrique 14, un capot 17 en forme de cuvette, délimitant une cavité 17a, dont on fixe le bord périphérique 18 sur la face avant 5 de la plaque support 1 et dont le fond 19 s'étend parallèlement à cette plaque support, à distance du capteur optique 13, et est en un matériau transparent. Sur trois de ses côtés, le bord 18 du capot 17 s'étend de façon adjacente au bord de la plaque support 1 tandis que son troisième côté traverse la face avant 5 de cette plaque support de façon à laisser une portion de cette face avant 5a non recouverte.

Dans une seconde variante d'exécution représentée sur la figure 3B, l'encapsulation précitée est obtenue en formant sur la face avant 5 de la plaque support 1 un bloc 20 en un matériau d'enrobage transparent dont la face avant 21 s'étend parallèlement à la plaque support 1 et en avant du capteur optique 13.

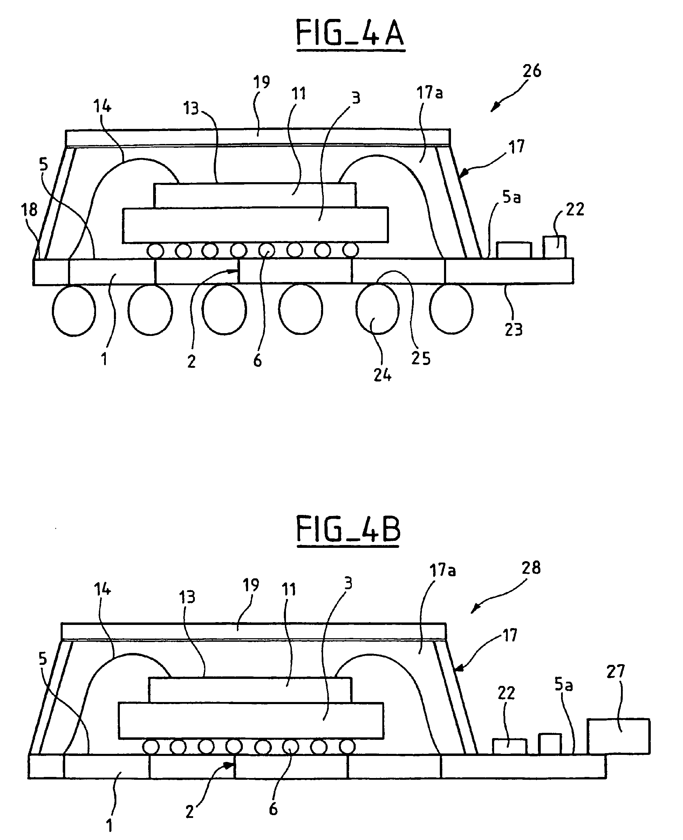

Dans une quatrième étape de fabrication, selon une première variante d'exécution représentée sur la figure 4A, on fixe des composants électroniques passifs 22, tels que des résistances et/ou des condensateurs, sur la partie découverte 5a de la face avant 5 de la plaque support 1, latéralement au capot 17 ou au bloc d'enrobage 20, ces composants électroniques 22 étant en même temps connectés électriquement au réseau 2 de la plaque support 1.

On fixe, par dépôt sur la face arrière 23 de la plaque support 1, une multiplicité de billes métalliques de connexion électrique extérieure 24 sur des plots métalliques 25 du réseau 2 prévus en surface sur cette face arrière 23 et répartis sous forme d'une matrice.

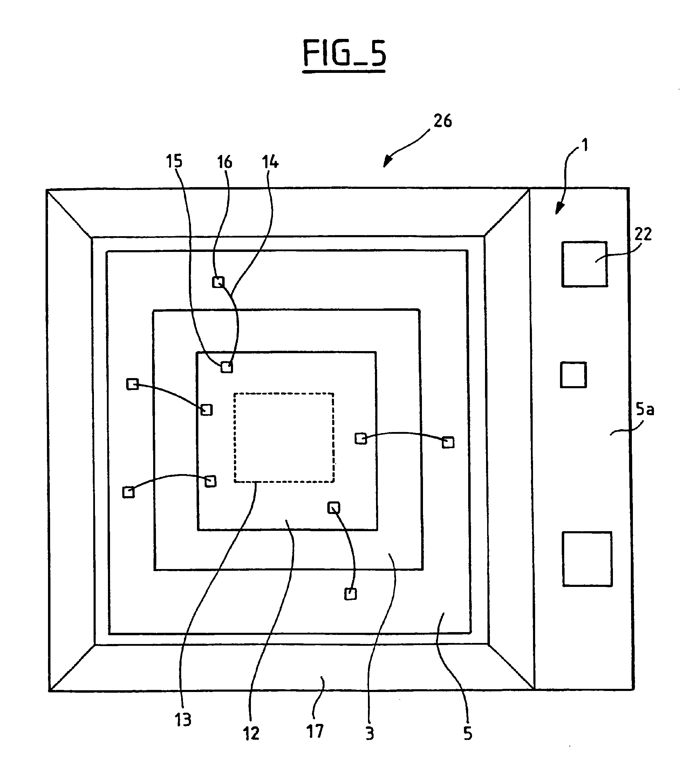

On obtient ainsi, comme le montrent les figures 4A et 5, un boîtier semi-conducteur optique 26 complet équipé d'un composant semi-conducteur optique 11 et de différents composants électroniques de traitement 3 et 22, reliés électriquement de façon adaptée par l'intermédiaire du réseau de connexion 2 de la plaque support 1 et susceptibles d'être connectés à un circuit extérieur grâce aux billes métalliques 24.

Dans la variante représentée sur la figure 4B, les billes métalliques 24 de connexion électrique extérieure sont remplacées par un organe de connexion électrique extérieure ou connecteur de branchement 27 fixé sur la face avant 5 de la face support 1, en bout de sa partie découverte 5a et connecté au réseau 2.

On obtient ainsi, comme le montre la figure 4B, un boîtier semi-conducteur optique 26 complet équipé d'un composant semi-conducteur optique 11 et de différents composants électroniques de traitement 3 et 22, reliés électriquement de façon adaptée par l'intermédiaire du réseau de connexion 2 de la plaque support 1 et susceptibles d'être connectés à un circuit extérieur grâce au connecteur de branchement 27.

La présente invention ne se limite pas aux exemples ci-dessus décrits. Bien de variantes de réalisation sont possibles sans sortir du cadre défini par les revendications annexées.

## Revendications

1. Boîtier semi-conducteur optique comprenant :
une plaque support (1) comprenant un réseau (2) de connexion électrique ;
un premier composant semi-conducteur (3) tel qu'un microprocesseur dont une face est portée par une face avant de ladite plaque support ;
un second composant semi-conducteur (11) dont une face avant comprend un capteur optique (13) et dont une face arrière est fixée sur une face avant dudit premier composant (3) ;
des premiers moyens de connexion électrique (6) dudit premier composant à la face avant de ladite plaque support ;
des seconds moyens de connexion électrique dudit second composant à la face avant de ladite plaque support comprenant des fils de connexion électrique (14) dont les extrémités sont respectivement connectées d'une part à la face avant dudit second composant (11) et d'autre part à la face avant de ladite plaque support (1)
et des moyens de connexion électrique extérieure (24) disposés sur une partie découverte de ladite plaque support ;
**caractérisé par le fait qu'**il comprend un bloc d'enrobage (20) en un matériau transparent formé sur la face avant (5) de ladite plaque support, encapsulant lesdits composants et lesdits moyens de connexion électrique et dont la face avant (21) s'étend parallèlement et en avant du capteur optique (13) ; et que ladite plaque support (1) porte, sur une partie découverte de sa face avant, des composants électroniques passifs (22) disposés à l'extérieur dudit bloc d'enrobage (20) et connectés électriquement audit réseau (2).

2. Boîtier selon la revendication 1, **caractérisé par le fait que** lesdits premiers moyens de connexion électrique (6) comprennent des billes de connexion électrique et de fixation interposées entre la face arrière dudit premier composant et la face avant de ladite plaque support.

3. Boîtier selon l'une des revendications 1 et 2, **caractérisé par le fait que** lesdits moyens de connexion électrique extérieure comprennent des billes de connexion électrique (24) disposées sur la face arrière de ladite plaque support opposée auxdits composants.

4. Boîtier selon l'une quelconque des revendications précédentes, **caractérisé par le fait que** lesdits moyens de connexion électrique extérieure comprennent un organe de branchement électrique (27) fixé sur ladite plaque support.

5. Boîtier selon la revendication 4, **caractérisé par le fait que** ledit organe de branchement électrique (27) est fixé sur la face avant de ladite plaque support (1).

6. Procédé de fabrication d'un bottier semi-conducteur optique, comprenant, successivement, les étapes suivantes :
- la fixation et la connexion électrique d'une face arrière d'un premier composant semi-conducteur (3) tel qu'un microprocesseur sur une face avant d'une plaque support de connexion électrique (1) qui comprend des lignes internes et/ou externes constituant un réseau (3) de connexions électriques présentant des zones et/ou plots de connexions électriques, par l'intermédiaire de billes de connexion électrique disposées entre des zones de connexion électrique desdites faces;
- la fixation de la face arrière d'un second composant semi-conducteur (11) dont une face avant comprend un capteur optique, sur une face avant dudit premier composant ;
- la fixation des extrémités de fils de connexion électrique (14) pour relier des zones de connexion électrique de la face avant dudit second composant et de la face avant de ladite plaque support ; **caractérisé par le fait qu'**il comprend, à la suite,
- l'encapsulation desdits composants empilés sur ladite plaque support (1) et desdits moyens de connexion électrique dans un bloc (20) en un matériau d'enrobage transparent formé sur la face avant (5) de ladite plaque support, encapsulant lesdits composants empilés sur cette plaque support et lesdits moyens de connexion électrique et dont la face avant (21) s'étend parallèlement et en avant du capteur optique (13),
- puis la fixation de moyens de connexion électrique extérieure (24) sur une partie découverte de ladite plaque support et la fixation de composants passifs (22) sur une partie découverte de la face avant de ladite plaque support et la connexion électrique de ces composants électroniques passifs audit réseau (2).

7. Procédé selon la revendication 6, caraétérisé par le fait que la fixation de moyens de connexion électrique extérieure comprend la dépose de billes de connexion électrique (24) sur des zones de connexion électrique prévues sur la face arrière de ladite plaque support (1).

8. Procédé selon l'une quelconque des revendications 6 et 7, **caractérisé par le fait que** la fixation de moyens de connexion électrique extérieure comprend la fixation d'au moins un organe de connexion électrique (27) sur des zones de connexion électrique prévues sur la face avant de ladite plaque support (1).

## Claims

1. Optical semiconductor package comprising:
a support plate (1) comprising an electrical connection network (2);
a first semiconductor component (3) such as a microprocessor, a face of which is supported by a front face of the said support plate;
a second semiconductor component (11), a front face of which has an optical sensor (13) and a rear face of which is fixed to a front face of the said first component (3);
first means (6) for electrical connection of the said first component to the front face of the said support plate;
second means for electrical connection of the said second component to the front face of the said support plate comprising electrical connection wires (14) whose ends are respectively connected, on one hand, to the front face of the said second component (11) and, on the other hand, to the front face of the said support plate (1); and
external electrical connection means (24) located on an exposed part of the said support plate;
**characterized in that** it comprises an encasing block (20) made of a transparent material formed on the front face (5) of the said support plate, encapsulating the said components and the said electrical connection means and the front face (21) of which extends parallel and forward of the optical sensor (13); and that the said support plate (1) carries, on an uncovered part of its front face, passive electronic components (22) disposed outside the said encasing block (20) and connected electrically to the said network (2).

2. Package according to Claim 1, **characterized in that** the said first electrical connection means (6) comprise electrical connection balls fixed and inserted between the rear face of the said first component and the front face of the said support plate.

3. Package according to either of Claims 1 and 2, **characterized in that** the said external electrical connection means comprise electrical connection balls (24) located on the rear face of the said support plate opposite the said components.

4. Package according to any one of the preceding claims, **characterized in that** the said external electrical connection means comprise an electrical connection body (27) fixed to the said support plate.

5. Package according to Claim 4, **characterized in that** the said electrical connection body (27) is fixed to the front face of the said support plate (1).

6. Process for fabricating an optical semiconductor package, comprising, successively, the following stages:
- fixing and electrically connecting a rear face of a first semiconductor component (3) such as a microprocessor to a front face of an electrical connection support plate (1) which comprises internal and/or external lines constituting a network (3) of electrical connections exhibiting electrical connection zones and/or pads, via electrical connection balls located between electrical connection regions of the said faces;
- fixing the rear face of a second semiconductor component (11), a front face of which has an optical sensor, to a front face of the said first component;
- fixing the ends of electrical connection wires (14) in order to connect electrical connection regions of the front face of the said second component and of the front face of the said support plate;
**characterized in that** it comprises, in succession,
- the encapsulation of the said components stacked on the said support plate (1) and of the said electrical connection means in a block (20) of a transparent encasing material formed on the front face (5) of the said support plate, encapsulating the said components stacked on this support plate and the said electrical connection means and the front face (21) of which extends parallel and forward of the optical sensor (13),
- then the fixing of means of exterior electrical connection (24) onto an uncovered part of the said support plate and the fixing of passive electronic components (22) onto an uncovered part of the front face of the said support plate and the electrical connection of these passive electronic components to the said network (2).

7. Process according to Claim 6, **characterized in that** fixing the external electrical connection means comprises depositing electrical connection balls (24) on electrical connection regions provided on the rear face of the said support plate (1).

8. Process according to either of Claims 6 and 7, **characterized in that** fixing external electrical connection means comprises fixing at least one electrical connection body (27) to electrical connection regions provided on the front face of the said support plate (1).

## Patentansprüche

1. Optisches Halbleitergehäuse, umfassend:
eine Stützplatte (1), umfassend ein elektrisches Anschlussnetz (2);
eine erste Halbleiterkomponente (3), wie beispielsweise einen Mikroprozessor, von dem eine Fläche von einer vorderen Fläche der Stützplatte getragen wird;
eine zweite Halbleiterkomponente (11), von der eine vordere Fläche einen optischen Sensor (13) umfasst, und eine rückwärtige Fläche auf einer vorderen Fläche der ersten Komponente (3) befestigt ist;
erste elektrische Anschlussmittel (6) der ersten Komponente an die vordere Fläche der Stützplatte;
zweite elektrische Anschlussmittel der zweiten Komponente an die vordere Fläche der Stützplatte, umfassend elektrische Anschlussdrähte (14), deren Enden einerseits an die vordere Fläche der zweiten Komponente (11) bzw. andererseits an die vordere Fläche der Stützplatte (1) angeschlossen sind, und äußere elektrische Anschlussmittel (24), die auf einem abgedeckten Teil der Stützplatte angeordnet sind;
**dadurch gekennzeichnet, dass** es einen Umhüllungsblock (20) aus einem transparenten Material umfasst, der auf der vorderen Fläche (5) der Stützplatte ausgebildet ist und die Komponenten und die elektrischen Anschlussmittel umhüllt, und dessen vordere Fläche (21) sich parallel und vor dem optischen Sensor (13) erstreckt; und dass die Stützplatte (1) auf einem abgedeckten Teil ihrer vorderen Fläche passive elektronische Komponenten (22) trägt, die außerhalb des Umhüllungsblocks (20) angeordnet und elektrisch ans Netz (2) angeschlossen sind.

2. Gehäuse nach Anspruch 1, **dadurch gekennzeichnet, dass** die ersten elektrischen Anschlussmittel (6) elektrische Anschluss- und Befestigungskugeln umfassen, die zwischen der rückwärtigen Fläche der ersten Komponente und der vorderen Fläche der Stützplatte angeordnet sind.

3. Gehäuse nach einem der Ansprüche 1 und 2, **dadurch gekennzeichnet, dass** die äußeren elektrischen Anschlussmittel elektrische Anschlusskugeln (24) umfassen, die auf der rückwärtigen Fläche der Stützplatte, die den Komponenten gegenüberliegt, angeordnet sind.

4. Gehäuse nach einem der vorhergehenden Ansprüche, **dadurch gekennzeichnet, dass** die äußeren elektrischen Anschlussmittel ein elektrisches Anschlusselement (27) umfassen, das an der Stützplatte befestigt ist.

5. Gehäuse nach Anspruch 4, **dadurch gekennzeichnet, dass** das elektrische Anschlusselement (27) auf der vorderen Fläche der Stützplatte (1) befestigt ist.

6. Verfahren zur Herstellung eines optischen Halbleitergehäuses, umfassend die folgenden Schritte hintereinander:
Befestigung und elektrischer Anschluss einer rückwärtigen Fläche einer ersten Halbleiterkomponente (3), wie eines Mikroprozessors, an eine vordere Fläche einer Stützplatte (1) für den elektrischen Anschluss, die interne und/oder externe Leitungen umfasst, die ein elektrisches Anschlussnetz (3) darstellen, das elektrische Anschlusszonen und/oder -punkte über elektrische Anschlusskugeln, die zwischen den elektrischen Anschlusszonen der Flächen angeordnet sind, aufweist;
Befestigung der rückwärtigen Fläche einer zweiten Halbleiterkomponente (11) von der eine vordere Fläche einen optischen Sensor umfasst, auf einer vordere Fläche der ersten Komponente;
Befestigung der Enden von elektrischen Anschlussdrähten (14), um elektrische Anschlusszonen der vorderen Fläche der zweiten Komponente und der vorderen Fläche der Stützplatte zu verbinden;
**dadurch gekennzeichnet, dass** es anschließend umfasst:
die Umhüllung der auf der Stützplatte (1) gestapelten Komponenten und der elektrischen Anschlussmittel mit einem Block (20) aus einem transparenten Umhüllungsmaterial, der auf der vorderen Fläche (5) der Stützplatte ausgebildet ist, wobei die auf dieser Stützplatte gestapelten Komponenten und die elektrischen Anschlussmittel umhüllt werden, und dessen vordere Fläche (21) sich parallel und vor dem optischen Sensor (13) erstreckt,
dann Befestigung der äußeren elektrischen Anschlussmittel (24) auf einem abgedeckten Teil der Stützplatte und Befestigung von passiven elektronischen Komponenten (22) auf einem abgedeckten Teil der vorderen Fläche der Stützplatte und elektrischer Anschluss dieser passiven elektronischen Komponenten an das Netz (2).

7. Verfahren nach Anspruch 6, **dadurch gekennzeichnet, dass** die Befestigung von äußeren elektrischen Anschlussmitteln das Aufbringen von elektrischen Anschlusskugeln (24) auf elektrische Anschlusszonen, die auf der rückwärtigen Fläche der Stützplatte (1) vorgesehen sind, umfasst.

8. Verfahren nach einem der Ansprüche 6 und 7, **dadurch gekennzeichnet, dass** die Befestigung von äußeren elektrischen Anschlussmitteln die Befestigung mindestens eines elektrischen Anschlusselements (27) auf elektrischen Anschlusszonen, die auf der vorderen Fläche der Stützplatte (1) vorgesehen sind, umfasst.
